Europäisches Patentamt

European Patent Office

Office européen des brevets

(19)

(11) Publication number: **0 360 164**
**A2**

(12) # EUROPEAN PATENT APPLICATION

(21) Application number: **89117091.2**

(22) Date of filing: **15.09.89**

(51) Int. Cl.5: **H03K 19/173**

(30) Priority: **20.09.88 US 246849**

(43) Date of publication of application:
**28.03.90 Bulletin 90/13**

(84) Designated Contracting States:
**DE FR GB IT NL**

(71) Applicant: **NATIONAL SEMICONDUCTOR
CORPORATION
2900 Semiconductor Drive P.O. Box 58090
Santa Clara California 95051-8090(US)**

(72) Inventor: **Roberts, Scott K.
3213 25th Avenue Court SE
Puyallup, WA 98374(US)**
Inventor: **Tibbits, Stephen A.
1920 S. 161st Street
Spanaway, WA 98387(US)**
Inventor: **Gabel, Bradley L.
7008 141st Street Court E
Puyallup, WA 98373(US)**

(74) Representative: **Sparing - Röhl - Henseler
Patentanwälte
Rethelstrasse 123 Postfach 14 02 68
D-4000 Düsseldorf 1(DE)**

(54) Standard cell output driver connection system.

(57) Gates in standard cells for gate arrays and application-specific integrated circuits and divided into a logic element primitive and a driving element primitive to reduce the number of standard cells which need to be designed and laid out. A connection scheme is provided to connect the logic element of the standard cell to more than two output drivers or emitter followers. Each emitter follower includes an input and an output pin for connection to the switch or logic element output, and another pair of pins which provide a passthrough that emitter follower to the next emitter follower. By abutting the emitter followers to each other, the crossover connections permit an expansion of the number of usable output pins from the emitter follower.

FIG. 3

# STANDARD CELL OUTPUT DRIVER CONNECTION SYSTEM

This invention relates to standard cell libraries and in particular to a system for connecting logic elements to interchangeable output drivers in an efficient manner which allows the output drivers to be modified based upon the actual load being driven.

The evolving world of bipolar large-scale integrated circuits requires a suitable technology, automated design, circuit verification and test capability. One advanced bipolar technology provides self-aligned bipolar devices with a single level of polycrystalline silicon. This technology is known as ASPECT or advanced single poly emitter-coupled technology. Using this process allows the design of circuits which have high density and high speed with a minimum feature size of less than two microns, and transistor switching in the 3 GigaHertz range.

The use of standard cells is one of the most promising techniques for the automated design of application-specific integrated circuits or ASICs; however, standard bipolar cells present unique design problems. To gain the highest performance in bipolar and emitter-coupled logic cells, custom or manual cell layer is essential. While a CMOS standard cell family with many different logic functions can be created from a few device level primitives, ECL requires a more complex family of cells. To complete successfully requires the design of hundreds of possible cells in a reasonable amount of time, while maintaining very high performance levels. In addition, the designer of such an ASIC cell library must compensate for the fact that a larger percentage of the gate delay in such circuits will be caused by the parasitic capacitance of the interconnect lines. Furthermore, the design of such devices requires care on the part of the designer in view of the limitation that each switching element was limited to having at most two outputs.

In the prior art, output drivers were often provided in emitter-coupled logic gate arrays by using multiple components placed in every cell, and then selectively connecting those components based upon the drive capability needed. Unfortunately, this wastes area in that not all components are used all of the time. Furthermore, it is inflexible because only the components originally defined are available. In other standard cell techniques, different cells with different powered emitter followers were integrated into the cell. Unfortunately, by proceeding in this manner, the number of cells quickly becomes large. For example, with 150 base cells and three to five power options each, there will be 450-750 cells to design, layout, and maintain in inventory.

This invention separates the driver from the logic element and provides a technique for connecting a switch or logic element of a standard cell to more than two output drivers, typically emitter followers, for that cell. The emitter followers, or output drivers, are abutted side to side and interconnected by crossover connections to expand the number of usable output pins from the switch element. The invention provides a technique which is expandable to any number of pins or any number of emitter followers. The technique of the invention is particularly suited for ECL standard cell libraries and high density bipolar circuits. The invention allows circuit operating speed to be optimized based upon the actual line length loading, the fanout loading, and critical path requirements. In addition, because the invention separates the emitter followers from the switching elements, it minimizes the number of cells to be manually laid out. For example, using about 150 primitive cells and two groups of five emitter follower cells allows for more than 10,000 combinations, yet only 160 primitive layouts and schematics, and 300 macroschematics need to be prepared. In addition, the invention permits the addition of further emitter follower groups whenever needed. For example, specialized high drive buffers may be readily employed using the invention.

Figure 1 is a schematic of a two-input OR/NOR logical primitive.

Figure 2 is a schematic of an emitter follower primitive.

Figure 3 is a schematic of an active current source with a level shifter.

Figure 4 is a block diagram of a standard cell output driver system showing four independent outputs.

Figure 5 is a block diagram of a standard cell output driver system employing multiple emitter followers.

We have developed a system for overcoming the foregoing disadvantages of prior art application-specific integrated circuits and standard cells. Our approach consists of separating the switching or logic element from the output driver to create different primitives. As used herein the term output driver is usually synonymous with emitter follower. Thus, the standard cell library consists largely of two types of basic cells-logical primitives and output driver primitives. By combining the primitives, standard cells are produced.

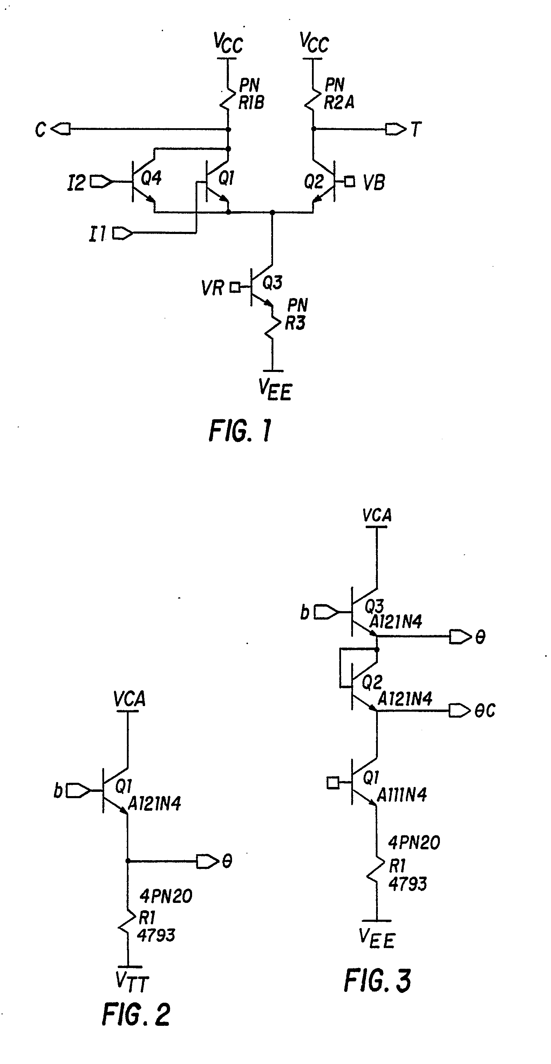

The logical primitive group consists of logical gating functions such as OR, AND, MUX, ADD, etc. Figure 1 is an example of a two-input OR/NOR primitive. In the physical layout of these primitives, the true T and complement C output pins are on opposite sides, while the input pin I1 and I2 are accessed from the top and bottom of the cells. This enables the emitter follower cells to be abutted against the sides of the logical function cells as will be described further below. Some of the logical primitives have reduced voltage swings to allow common mode or emitter-coupled logic configurations.

Figure 2 is a schematic of an emitter follower. The emitter follower primitive shown in Figure 2 provides the line driving capability of the logic primitive, typically an ECL gate, and enables the primitive to be designed in a variety of power and voltage levels. Each group of emitter followers is designed to have the same physical size and footprint to allow interchangeability after routing of the chip.

A relative small number of these primitives enables fabrication of a large number of cells where each cell is a combination of a logical primitive and and emitter follower primitive. For example, if there are five different power levels of the output driver shown in Figure 2, each of these five can be combined with the gate shown in Figure 1 to provide 35 different possible cells. Therefore, five power levels of each of two input OR/NOR gate and 25 power combinations of the OR/NOR gate can be generated. Thus, the structured design approach we have developed minimizes the amount of tedious manual layout. Of the 35 cells described above, only the three macros which differ logically from each other need to be represented to the design system, with all other permutations of power levels being generated automatically by the methodology described below.

Figure 3 is a schematic of a different output primitive in which an active current source is combined with a level shifting capability. This is an example of a different output driver primitive.

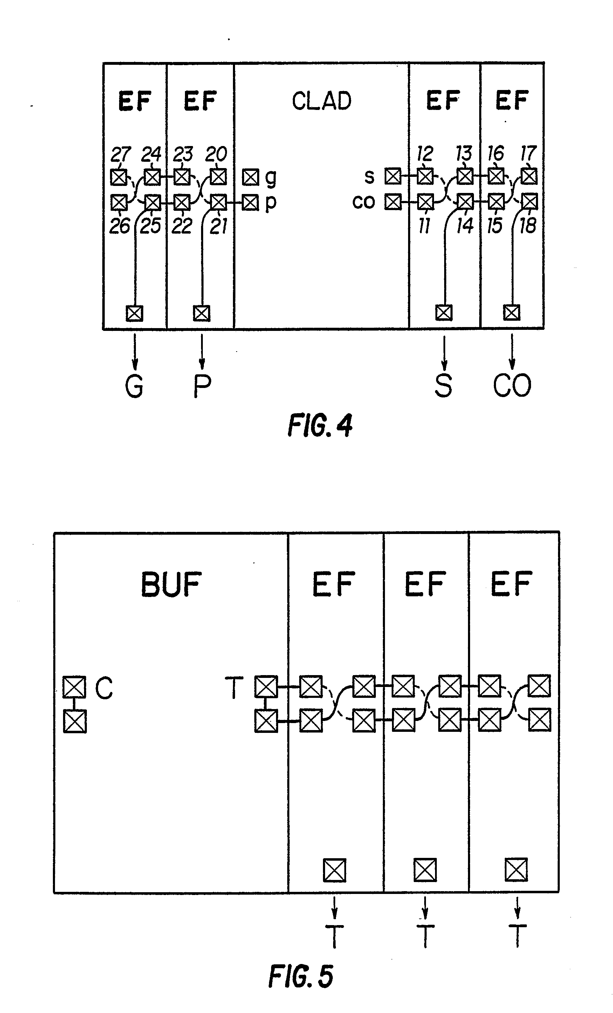

Figure 4 is a block diagram showing how a single switch or logic element may be connected to drive several different outputs by employing a corresponding number of emitter follower stages. This invention provides a technique for interconnecting the emitter followers to the switch, even though those emitter followers are situated remotely from the switch, for example, as in the case of the followers driving outputs G and CO. The crossover connection shown in Figure 4 makes this possible, while at the same time allowing each emitter follower cell to be identical in footprint and interchangeable. The pins numbered with even numbers in Figure 2 make connection to the emitter follower input terminals, while the pins numbered with odd numbers provide a passthrough to the next emitter follower stage. The technique is expandable to any number of pins or emitter follower stages. For example, Figure 5 is a block diagram illustrating the use of three emitter follower stages to generate identical outputs T from a buffer cell.

The performance of large-scale integrated circuits is governed by two primary components. First is the intrinsic delay of the logic gate, and second is the delay caused by the signal interconnection loading and fanout. For a typical logic gate in the preferred ASPECT technology, the intrinsic delay will be on the order of 225 picoseconds. The signal interconnect loading and fanout delay can add 25 picoseconds per hundred microns of wiring by capacitive loading. Using our invention the output drive of an ECL gate can be adjusted by changing the power in the emitter follower primitive. Using our technique in the critical paths, the emitter follower primitives can be replaced by higher power versions based on the loading which is determined after routing.

The major steps of a standard cell system employing our invention are:

(1) Complete the architectural and high level logic diagrams.

(2) Partition the design and identify areas which require custom blocks. Generally, the custom blocks arise in memory arrays, adder arrays and other blocks that consist of arrayable cells.

(3) Implement the detailed logic using a standard cell library and verify it using suitable software.

(4) Complete the logic and timing simulations.

(5) Determine the plan of the chip and place and route the design.

(6) Extract the net loading from the layout.

(7) Determine the critical loading paths.

(8) Tighten the target delay values on the critical path nodes.

(9) Adjust the emitter follower power based upon loading and the target path nodes.

(10) Add the power routing and bonding pad locations.

(11) Verify the design using suitable software for automated design rule checking and layout verses schematic verification.

(12) As the above steps are performed, generate the test vectors and determine testability of the circuit.

In the foregoing methodology, steps 7-9 distinguish our method from the classical standard cell layout technology. Equations derived from the simulations of loading versus delay allow programmatic substitution of emitter followers based on the routing capacitance, fanout, and critical path requirements.

Each cell in the logic design will have a target property associated with it. The value of this target property indicates the amount of delay that will be tolerated. If the simulated delay exceeds the target value, then the step 9 the system exchanges the existing emitter follower primitive with a higher power version. Initially, the values of these targets default to a relatively large number to avoid increasing the power of other cells that are not in the critical path. After the first placement and routing stage, the total alternating current load (capacitance) is determined for each net from both the net lengths and fanout. The critical path analysis then indicates which paths have the longest delays, and within each critical path each macrodelay is related to the loading. The target values are then tightened in the paths with the longest dealys and step 9 is repeated. This critical path analysis is executed repeatedly until the incremental gain by substituting higher power emitter follows in negligible.

Our invention provides a high performance automated standard cell design system in which the number of primitive cells is reduced and performance of the ultimately designed circuit is improved. In the preceding, specific circuits, primitives and cells have been described to illustrate the invention. The scope of the invention should be ascertained from the appended claims.

## Claims

1. A standard cell system comprising:
a first plurality of logic elements adapted to perform logic operations on input signals supplied to each of them, and in response provide first output signals; and
a second plurality of output drivers adapted to receive the first output signals and supply them to other logic elements, wherein the logic elements and the output drivers are selectively connectable to each other to provide a larger plurality of standard cells.

2. An output driver for a logic element, the driver comprising:
a first connection for coupling the logic element to an output terminal; and
a second connection for coupling the logic element to another output driver not disposed adjacent to the logic element.

EP 0 360 164 A2

*FIG. 1*

*FIG. 2*

*FIG. 3*

FIG. 4

FIG. 5